(19) Europäisches Patentamt

European Patent Office

Office européen des brevets

(11) EP 1 072 957 B1

(12) **EUROPÄISCHE PATENTSCHRIFT**

(45) Veröffentlichungstag und Bekanntmachung des Hinweises auf die Patenterteilung:
**27.12.2006 Patentblatt 2006/52**

(51) Int Cl.:
***G03F 7/20*** *(2006.01)*

(21) Anmeldenummer: **00115730.4**

(22) Anmeldetag: **21.07.2000**

(54) **Beleuchtungssystem mit mehreren Lichtquellen**

Illumination system with multiple light sources

Système d' illumination avec sources lumineuses multiples

(84) Benannte Vertragsstaaten:
**DE FR GB IT NL**

(30) Priorität: **30.07.1999 DE 19935404**

(43) Veröffentlichungstag der Anmeldung:
**31.01.2001 Patentblatt 2001/05**

(73) Patentinhaber: **Carl Zeiss SMT AG
73447 Oberkochen (DE)**

(72) Erfinder:
• **Schultz, Jörg
73430 Aalen (DE)**
• **Rothweiler, Dirk, Dr.
73434 Aalen (DE)**

(74) Vertreter: **Sawodny, Michael-Wolfgang
Adolf - Lüken - Höflich - Sawodny,
Dreiköniggasse 10
89073 Ulm (DE)**

(56) Entgegenhaltungen:
EP-A- 0 955 641  US-A- 5 439 781
US-A- 5 815 248

• PATENT ABSTRACTS OF JAPAN Bd. 017, Nr. 338 (P-1564), 25. Juni 1993 (1993-06-25) -& JP 05 045605 A (ASAHI OPTICAL CO LTD), 26. Februar 1993 (1993-02-26)

## Beschreibung

Die Erfindung betrifft ein Beleuchtungssystem für Wellenlängen ≤ 193 nm, also beispielsweise die VUV- und die EUV-Lithographie mit mehreren Lichtquellen sowie einer Spiegel- oder Linsenvorrichtung zur Erzeugung sekundärer Lichtquellen umfassend mehrere Spiegel oder Linsen, der bzw. die in Rasterelemente gegliedert sind.

Um die Strukturbreiten für elektronische Bauteile noch weiter reduzieren zu können, insbesondere in den Submikronen-Bereich, ist es erforderlich, die Wellenlängen des für die Mikrolithographie eingesetzten Lichtes zu verringern.

Denkbar ist bei Wellenlängen kleiner als 193 nm beispielsweise die Lithographie mit weichen Röntgenstrahlen, die sogenannte EUV-Lithographie.

Ein für die EUV-Lithographie geeignetes Beleuchtungssystem soll mit möglichst wenigen Reflektionen das für die EUV-Lithographie vorgegebene Feld, insbesondere das Ringfeld eines Objektives entsprechend den Lithographie-Anorderungen homogen, d.h. uniform ausleuchten, des weiteren soll die Pupille des Objektives feldunabhängig bis zu einem bestimmten Füllgrad σ ausgeleuchtet werden und die Austrittspupille des Beleuchtungssystems in der Eintrittspupille des Objektives liegen.

Betreffend den prinzipiellen Aufbau von EUV-Beleuchtungssystemen wird auf die anhängigen Anmeldungen EP 99106348.8, eingereicht am 02.03.1999, mit dem Titel "Beleuchtungssystem, insbesondere für die EUV-Lithographie", veroffentlicht als EP 0 955 641, US-Serial No. 09/305, 017, eingereicht am 04.05.1999 mit dem Titel "Illumination-System particularly für EUV-Lithography" veroffentlicht als US 6 198 793, sowie PCT/EP 99/02999, eingereicht am 04.05.1999, mit dem Titel "Beleuchtungssystem, insbesondere für die EUV-Lithographie" der Anmelderin veroffentlichtals WO 99/57732, verwiesen, die alle nicht Teil des Stands der Technik nach Artikel 54(2) EPÜ sind

Als Lichtquellen für EUV-Beleuchtungssysteme werden derzeit diskutiert:

Laser-Plasma-Quellen
Pinch-Plasma-Quellen
Synchrotron-Strahlungsquellen

Bei Laser-Plasma-Quellen wird ein intensiver Laserstrahl auf ein Target (Festkörper, Gasjet, Tröfpchen) fokussiert. Durch die Anregung wird das Target so stark erhitzt, daß ein Plasma entsteht. Dieses emittiert EUV-Strahlung.

Typische Laser-Plasma-Quellen weisen eine kugelförmige Abstrahlung auf, das heißt einen Abstrahlwinkel von 4 π sowie einen Durchmesser von 50 $\mu$m bis 200 $\mu$m.

Bei Pinch-Plasma-Quellen wird das Plasma über elektrische Anregung erzeugt.

Pinch-Plasma-Quellen lassen sich als Volumenstrahler (D = 1.00 mm) beschreiben, die in 4 π abstrahlen, wobei die Abstrahlcharakteristik durch die Quellgeometrie gegeben ist.

Bei Synchrotronstrahlungsquellen kann man derzeit drei Arten von Quellen unterscheiden:

-  Bending-Magneten
-  Wiggler
-  Undulatoren

Bei Bending-Magnet-Quellen werden die Elektronen durch einen Bending-Magneten abgelenkt und Photonen-Strahlung emittiert.

Wiggler-Quellen umfassen zur Ablenkung des Elektrons beziehungsweise eines Elektronenstrahles einen sogenannten Wiggler, der eine Vielzahl von aneinander gereihten abwechselnd gepolten Magnetpaaren umfaßt. Durchläuft ein Elektron einen Wiggler, so wird das Elektron einem periodischen, vertikalen Magnetfeld ausgesetzt; das Elektron oszilliert dementsprechend in der horizontalen Ebene. Wiggler zeichnen sich weiter dadurch aus, daß keine Kohärenzeffekte auftreten. Die mittels eines Wigglers erzeugte Synchrotronstrahlung ähnelt der eines Bending-Magneten und strahlt in einen horizontalen Raumwinkel ab. Sie weist im Gegensatz zum Bending-Magneten einen um die Anzahl der Pole des Wicklers verstärkten Fluß auf.

Der Übergang von Wiggler-Quellen zu Undulator-Quellen ist fließend.

Bei Undulator-Quellen werden die Elektronen im Undulator einem Magnetfeld mit kürzerer Periode und geringerem Magnetfeld der Ablenkpole als beim Wiggler ausgesetzt, so daß Interferenz-Effekte der Synchrotronstrahlung auftreten. Die Synchrotronstrahlung weist aufgrund der Interferenzeffekte ein diskontinuierliches Spektrum auf und strahlt sowohl horizontal wie vertikal in ein kleines Raumwinkelelement ab; das heißt die Strahlung ist stark gerichtet.

Entscheidend für ein EUV-Beleuchtungssystem ist die Bereitstellung eines ausreichend hohen Lichtleitwertes, d.h. Lagrange optische Invariante oder Etendu. Der Lichtleitwert oder die Lagrange optische Invariante eines Systems ist definiert als das Produkt von beleuchteter Fläche x Apertur im Quadrat.

Fordert man eine Apertur in der Waferebene von $NA_{Wafer}$ = 0.1-0.25, so bedeutet dies bei 4:1 Systemen eine Apertur in der Retikelebene von $NA_{Retikel}$ = 0.025-0.0625. Soll das Beleuchtungssystem diese Apertur bis zu einem Füllgrad von beispielsweise σ = 0.6 homogen und feldunabhängig ausleuchten, so muß die EUV-Quelle über folgenden 2-dim-Lichtleitwert (LLW), d. h. Lagrange optische Invariante oder Etendu verfügen:

$$LLW_{Bel.} = \sigma^2 \ LLW_{Obj} = 0.149 \ mm^2 - 0.928 \ mm^2$$

verfügen. Der Lichtleitwert LLW, d. h. die Lagrange optische Invariante, ist für das betrachtete Lithographiesystem wie folgt allgemein definiert:

$LLW_{Bel} = \sigma^2 x \cdot y \cdot NA^2 = \sigma^2 A \cdot NA^2$, wobei A die ausgeleuchtete Fläche ist.

A beträgt in der Retikelebene z.B. 110 mm x 6 mm.

Der Lichtleitwert einer Laser-Plasma-Quelle läßt sich abschätzen als das Produkt der ausgeleuchteten Fläche einer gedachten Einheitskugel um die Quelle und den Aperturwinkel[2], unter dem jeder Feldpunkt die Kugelquelle sieht.

$$LLW \quad = A \cdot NA^2$$

$$A^{LPQ} \quad = 2\pi[\cos(\theta_1)-\cos(\theta_2)]$$

$$NA \quad \approx r_{Quelle} / 1 \ mm = 0.100$$

wobei $\theta_1$ der minimale Abstrahlwinkel bezüglich der optischen Achse ist und $\theta_2$ der maximale Abstrahlwinkel bezüglich der optischen Achse

$$LLW_{LPQ} = 2\pi[\cos(\theta_1) - \cos(\theta_2)] \cdot r_{LPQ}^2$$

Mit den typischen Quellparametern:

1. $r_{LPQ}$ = 0.1 mm, $\theta_1$ = 0°, $\theta_2$ = 90° ergibt sich: $LLW_{LPQ}$ = 0.063 $mm^2$. Dies entspricht 27 % des beispielsweise geforderten Lichtleitwertes $LLW_{Bel}$ von beispielsweise 0,236 $mm^2$.

2. $r_{LPQ}$ = 0.025 mm, $\theta_1$ = 0°, $\theta_2$ = 90° ergibt sich: $LLW_{LPQ}$ = 0.0039 $mm^2$. Dies entspricht 1.7 % des beispielsweise geforderten Lichtleitwertes von beispielsweise $LLW_{Bel}$ = 0,236 $mm^2$.

Der Lichtleitwert $LLW_{Pinch}$ einer beispielhaften Pinch-Plasma-Quelle mit Durchmesser = 1 mm, Ω = 0,3 sr beträgt:

$$LLW_{Pinch} = A \cdot NA^2 = \pi \cdot 1 \ mm^2 / 4 \cdot 0.3053^2 = 0.073 \ mm^2.$$

Die Pinch-Plasma-Quelle stellt somit 31 % des beispielsweise geforderten Lichtleitwertes von beispielsweise $LLW_{Bel}$ = 0,236 $mm^2$ zur Verfügung.

Der Lichtleitwert, d. h. die Langrange optische Invariante oder Etendu, für die Undulator-Quelle läßt sich nach einem vereinfachten Modell bei Annahme eines homogenen Flächenstrahlers mit Durchmesser

$$\varnothing = 1.0 \text{ mm und Apertur } NA_{Und} = 0.001$$

mit

$$LLW_{Und} = A \cdot NA^2$$

$$A_{Und} = \pi \cdot (\varnothing /2)^2$$
$$= 0.785 \text{ mm}^2$$

$$NA_{Und} = 0.001$$

zu

$$LLW_{Und} = A \cdot NA^2 = 0.00000079 \text{ mm}^2 = 7.9e\text{-}07 \text{ mm}^2$$

abschätzen.

Wie aus dieser Abschätzung zu ersehen, ist der Lichtleitwert der Undulatorquelle im Vergleich zum geforderten Lichtleitwert viel zu klein.

Zur Erhöhung des Lichtleitwertes ist aus der US 5,512,759 ein Beleuchtungssystem mit einer Synchroton-Strahlungsquelle bekanntgeworden, das ein Kondensorsystem mit einer Vielzahl von Sammelspiegeln umfaßt, die die von der Synchroton-Strahlungsquelle abgegebene Strahlung sammeln, zu einem ringförmigen Lichtstrahl formen, der mit dem ringförmig auszuleuchtenden Feld korrespondiert. Hierdurch wird das ringförmige Feld sehr gleichmäßig ausgeleuchtet. Die Synchrotron-Strahlungsquelle weist in der Abstrahlebene eine Strahldivergenz > 100 mrad auf.

Die US 5,439,781 zeigt ein Beleuchtungssystem mit einer Synchroton-Strahlungsquelle, bei der der Lichtleitwert, d. h. die Lagrange optische Invariante mit Hilfe einer Streuscheibe in der Eintrittspupille des Objektives eingestellt wird, wobei die Streuscheibe eine Vielzahl von pyramidalen Strukturen aufweisen kann. Auch bei der US 5,439,781 weist die Synchrotron-Strahlungsquelle eine Strahldivergenz > 100 mrad auf. Die SynchrotronStrahlung wird auch in der US 5 439 781 gebündelt, beispielsweise mit Hilfe eines Kollektorspiegels.

Aufgabe der Erfindung ist es, eine einfach aufgebaute Anordnung anzugeben, mit der der in der Objekt- bzw. Retikelebene geforderte Lichtleitwert erhalten wird.

Bei einem System der oberbegrifflichen Art wird diese Aufgabe dadurch gelöst, daß mehrere Lichtquellen miteinander gekoppelt werden, um die Austrittspupille des Beleuchtungssystems bis zu einem vorgegebenen Füllgrad auszuleuchten. Ein system nach dem Oberbegriff des Anspruchs 1 ist in US 5 815 248 offenbart.

Die Kopplung mehrerer Lichtquellen führt gleichzeitig zu einer Intensitätssteigerung. Eine Kopplung mehrerer Lichtquellen ist so lange möglich, so lange der Gesamtlichtleitwert der gekoppelten Quellen geringer ist als der Lichtleitwert der Beleuchtung ($LLW_{Bel}$).

Zur Kopplung können prinzipiell drei Möglichkeiten unterschieden werden:

1. Additionsmethode: Gleiche oder ähnliche Beleuchtungssysteme werden um eine Systemachse verteilt angeordnet. Die Austrittspupille des Beleuchtungssystems wird dabei von den kreisförmigen Pupillen der Teilsysteme ausgeleuchtet, die sich nicht überlappen dürfen. Die Teilpupillen liegen auf den Seitenflächen eines pyramidenförmigen Einkoppelspiegels, der die Lichtbüschel auf dem Objekt bzw. Retikel überlagert.

2. Mischmethode: In diesem Fall leuchtet jedes Teilsystem die gesamte Austrittspupille des Beleuchtungssystems aus, jedoch mit lichtfreien Bereichen zwischen den sekundären Lichtquellen. Die einzelnen Gitter der sekundären Lichtquellen sind bei der Überlagerung versetzt angeordnet, um die Pupille gleichmäßig zu füllen. Der Koppelspiegel besteht aus einer Wabenplatte, deren Waben Pyramidenform haben. Jede Seitenfläche einer einzelnen Wabenpyramide wird dabei von einer sekundären Lichtquelle beleuchtet.

3. Segmentmethode: Ähnlich der Additionsmethode. Im Gegensatz zur Additionsmethode wird durch entsprechende Strahlenlenkung statt eines kreisförmigen Ausschnittes der Austrittspupille ein beliebig geformtes Segment ausgeleuchtet.

Bevorzugte Ausführungsformen der Erfindung, die mindestens von einer der obengenannten Methoden Gebrauch machen, sind Gegenstand der Unteransprüche.

Nachfolgend soll die Erfindung anhand der Zeichnungen beispielhaft beschrieben werden.

Es zeigen:

Figur 1      eine erste Ausführungsform der Erfindung, bei der das Licht mehrerer Lichtquellen gemäß der Additionsmethode überlagert wird.

Figur 2      die Anordnung der Feldwabenplatten auf einer gleichseitigen Pyramide.

Figur 3      die Ausleuchtung der Austrittspupille eines Systems gemäß Figur 1.

Figur 4      Ausleuchtung der Austrittspupille bei Kopplung von 3, 4, 5 und 6 Quellen.

Figur 5      eine zweite Ausführungsform der Erfindung, bei der das Licht mehrerer Lichtquellen gemäß der Additionsmethode in der Blendenebene gekoppelt wird.

Figur 6      eine dritte Ausführungsform der Erfindung, bei der Licht mehrerer Lichtquellen gemäß der Mischmethode in der Blendenebene gekoppelt wird.

Figur 7      Anordnung der Feldwaben auf den Feldwabenplatten eines Systems gemäß Figur 6.

Figur 8      Anordnung der sekundären Lichtquellen in der Blendenebene bei einem System gemäß Figur 6.

Figur 9      Ausschnitt aus der Pupillenwabenplatte eines Systems gemäß Figur 6 mit einer Vielzahl von Pyramiden, auf deren Flanken sich die Pupillenwaben befinden.

Figur 10     eine vierte Ausführungsform der Erfindung, bei der Licht mehrerer Lichtquellen, mit Hilfe abbildender Pupillenwaben gemäß der Mischmethode in der Blendenebene gekoppelt wird.

Figur 11     Ausleuchtung eines Segmentes der Pupillenwabenplatte bei einem System, das nach der Segmentmethode arbeitet.

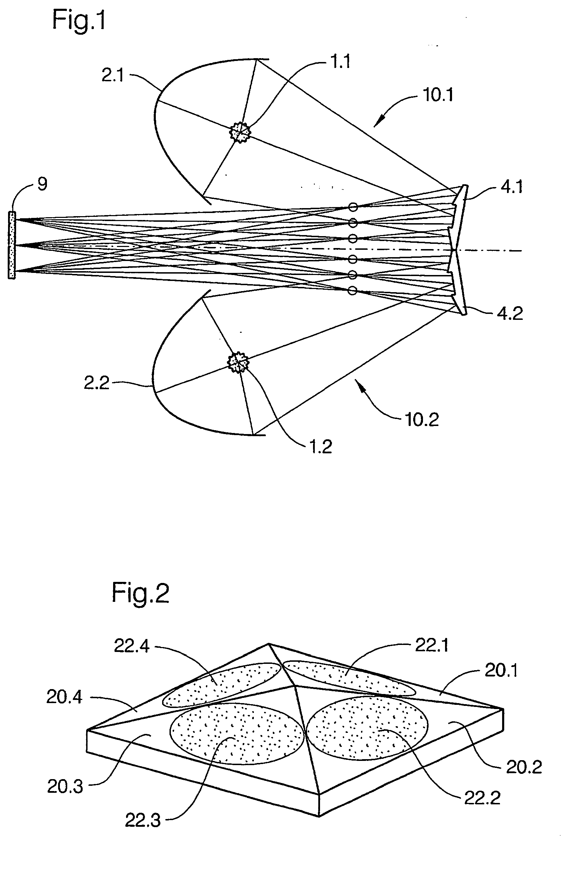

In Figur 1 ist der Aufbau eines Systems, bei dem die Lichtquellen nach der Additionsmethode miteinander gekoppelt werden, gezeigt. Als Lichtquellen 1.1, 1.2 werden vorliegend Lichtquellen mit kleinem Quelldurchmesser, vorliegend Laser-Plasma-Quellen angenommen.

Betreffend den prinzipiellen Aufbau von EUV-Beleuchtungssystemen wird auf die weiter oben erwähnten anhängigen Anmeldungen der Anmelderin verwiesen.

Jedes Teilsystem 10.1, 10.2 ist weitgehend gleich aufgebaut und umfaßt eine Lichtquelle 1.1, 1.2, einen Kollektorspiegel 2.1, 2.2 sowie eine Feldwabenplatte 4.1, 4.2.

Das Licht der jeweiligen Quelle wird mit Hilfe des zugeordneten Kollektorspiegels gesammelt und in ein paralleles oder konvergentes Lichtbüschel umgewandelt. Die Feldwaben der jeweiligen Feldwabenplatte 4.1, 4.2 zerlegen die Lichtbüschel und erzeugen in der Blendenebene des Beleuchtungssystems sekundäre Lichtquellen 6. Diese sekundären Lichtquellen werden durch die nicht dargestellte Feldlinse beziehungsweise Feldspiegel in die Austrittspupille des Beleuchtungssytems, die die Eintrittspupille des Objektives ist, abgebildet. Die Feldwaben der Feldwabenplatte sind auf der Platte so ausgerichtet und angeordnet, daß die Bilder der Feldwaben in der Retikelebene 9 sich überlagern.

Zusammengefügt werden die Systeme am Ort der Feldwabenplatten. Die Feldwabenplatten sitzen auf einer Pyramide, deren Seitenzahl der Anzahl der gekoppelten Teilsysteme entspricht. Der Neigungswinkel der Pyramidenseiten ist derart gewählt, daß die Feldausleuchtung der Teilsysteme in der Retikelebene 9 zur Deckung kommt.

Die Anordnung der Teilsysteme 10.1, 10.2 erfolgt derart, daß ihre Teilpupillen die Blendenebene des Beleuchtungssytems optimal füllen.

In der dargestellten Ausführungsform sind die Teilsysteme so orientiert, daß sie eine gemeinsame Systemachse besitzen. Der Winkelabstand der Teilsysteme beträgt dann 360° / Systemanzahl.

Für vier Teilsysteme ist in Figur 2 die Ausleuchtung der Pyramide, auf deren vier Seitenflächen 20.1, 20.2, 20.3, 20.4 im Bereich der ausgeleuchteten Fläche 22.1, 22.2, 22.3, 22.4 je eine Feldwabenplatte eines Teilsystems angeordnet ist, gezeigt.

Die Feldwaben sind so ausgerichtet und angeordnet, daß die Bilder in der Retikelebene 9 sich überlagern. Der Neigungswinkel der Pyramidenflächen 20.1, 20.2, 20.3, 20.4 ist so gewählt, daß die Feldausleuchtung der Teilsysteme in der Retikelebene zur Deckung kommt.

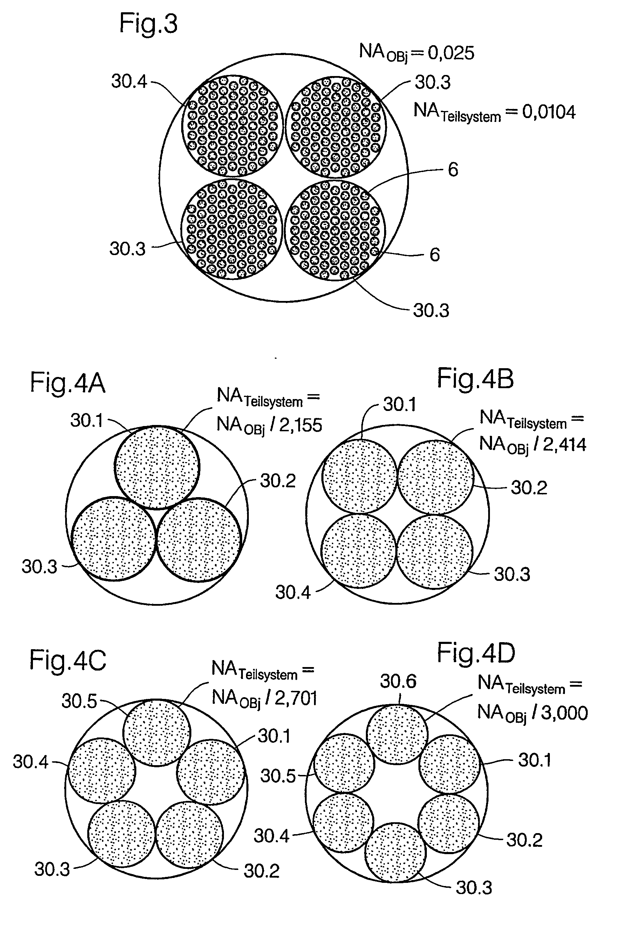

Die Ausleuchtung in der Blendenebene ist durch vier kreisförmige Teilpupillen 30.1, 30.2, 30.3, 30.4 wie in Figur 3 gezeigt gegeben, die wiederum entsprechend der Facettierung der Feldwabenplatten in einzelne sekundäre Lichtquellen 6 unterteilt sind.

In Figur 3 beträgt die Apertur des Gesamtsystems $NA_{obj}$ = 0.025 und die Apertur der Teilsysteme $NA_{Teilsystem}$ = 0.0104.

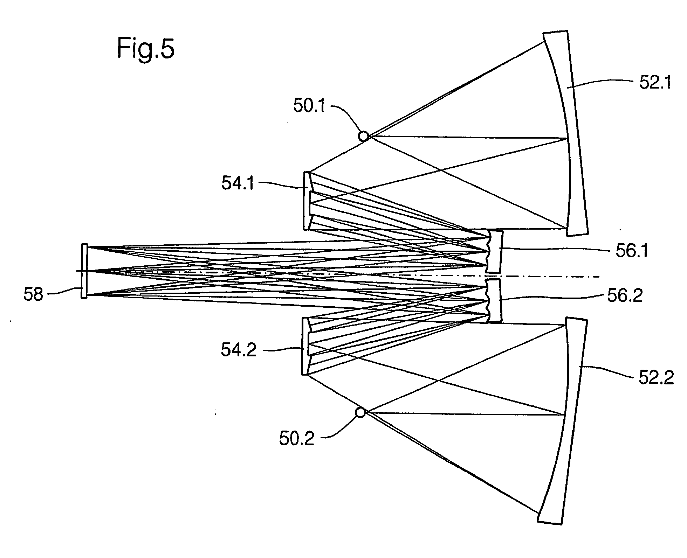

Je nach Anzahl der gekoppelten Teilsysteme kann man sich die in Figur 5 gezeigte Anordnung und Symmetrien der Teilpupillen 30.1, 30.2, 30.3, 30.4, 30.5, 30.6 vorstellen.

Die zulässigen Blendendurchmesser der Teilsysteme ergeben sich aus der Gesamtapertur $NA_{obj}$ des Objektivs in der Blendenebene und der Anzahl der Teilsysteme.

$$NA_{Teilsystem} = \frac{NA_{Obj}}{1 + \frac{1}{\sin\left(\frac{\pi}{Anzahl}\right)}}$$

Bei gefüllter Pupille jedes Teilssystems läßt sich die Pupille zu $\eta$% maximal ausleuchten.

$$\eta = Anzahl \cdot \frac{1}{\left(1 + \frac{1}{\sin\left(\frac{\pi}{Anzahl}\right)}\right)^2}$$

Die folgende Tabelle gibt $NA_{Teilsystem}$ und den Füllfaktor $\eta$ für $NA_{Obj}$ = 0.025:

| Anzahl Teilsysteme | $NA_{Teilsystem}$ | Füllfaktor $\eta_{max}$ |
|---|---|---|
| 2 | 0.0125 | 0.500 |
| 3 | 0.0116 | 0.646 |
| 4 | 0.0104 | 0.686 |
| 5 | 0.0093 | 0.685 |
| 6 | 0.0083 | 0.667 |
| 7 | 0.0076 | 0.641 |
| 8 | 0.0069 | 0.613 |
| 9 | 0.0064 | 0.585 |
| 10 | 0.0059 | 0.557 |

Hieraus ergibt sich, daß der maximal erreichbare Füllfaktor mit der Additionsmethode bei vier Teilsystemen und $NA_{obj}$ = 0.025 mit $\eta_{max} \approx 0.7$ erreicht wird. Als Nebenbedingung ist zu beachten, daß der Gesamtlichtwert der gekoppelten Quellen den Systemlichtleitwert $LLW_{Bel} = \sigma_{max} \cdot LLW_{obj}$ nicht überschreiten darf; also stets gelten muß:

$$\sum_{alle\ Quellen} LLW_i \leq LLW_{Bel} \cdot$$

In Figur 5 ist eine zweite Ausführungsform der Erfindung gezeigt, bei der als Lichtquellen 50.1, 50.2 zum Beispiel Pinch-Plasma-Quellen verwandt werden, die einen nicht zu vernachlässigenden Quelldurchmesser aufweisen.

Ein Teil-Beleuchtungssystem mit Pinch-Plasma-Quelle umfaßt die Lichtquelle 50.1, 50.2, einen Kollektorspiegel 52.1, 52.2, der das Licht sammelt und in die Feldwabenplatte 54.1, 54.2 beleuchtet. Die Feldwaben der Feldwabenplatte erzeugen sekundäre Lichtquellen. Am Ort der sekundären Lichtquellen sind auf einer Pupillenwabenplatte die Pupillenwaben angeordnet. Die Feldwaben der Feldwabenplatte dienen der Feldformung und die Pupillenwaben der Pupillenwabenplatte der korrekten Abbildung der Feldwaben in die Retikelebene. Bevorzugt ist jeder Feldwabe eine Pupillenwabe zugeordnet. Durch Reflexion an den Feldwaben wird das Licht zu den jeweiligen Pupillenwaben der Pupillenwabenplatte 56.1, 56.2 geführt und von dort zum Retikel, beispielsweise Objekt 58.

Zusammengefügt werden die Systeme am Ort der Pupillenwabenplatten. Die Pupillenwabenplatten sitzen auf einer Pyramide, deren Seitenzahl der Anzahl der gekoppelten Teilsysteme entspricht. Der Neigungswinkel der Pyramidenseiten ist derart gewählt, daß die Feldausleuchtung der Teilsysteme in der Retikelebene zur Deckung kommt.

Besitzen die Teilsysteme eine gemeinsame Systemachse, so beträgt der Winkelabstand der Teilsysteme 360° /Anzahl der Systeme und die Pupillenwabenplatten der Teilsysteme sind bevorzugt auf den Seitenflächen einer Pyramide wie in Figur 2 gezeigt angeordnet.

Der Vorteil der Additionsmethode bei Kopplung liegt darin, daß gleiche oder ähnliche Beleuchtungssysteme gekoppelt werden können. Die Wabenplatten der Teilsysteme sind getrennt und können somit separat gefertigt werden.

Bei der Additionsmethode ist zu beachten, daß sich Intensitätsunterschiede der einzelnen Quellen direkt in die Ausleuchtung der Pupille übertragen, so daß die Intensität der Teilpupillen somit durch die Quelleistung gegeben ist.

Die Intensitätsverteilung in der Blendenebene wird unabhängig von den Intensitäten der einzelnen Quellen, wenn man die sekundären Lichtquellen in der Pupillenebene mischt. Dieses Verfahren wird nachfolgend auch als Mischmethode bezeichnet.

Während sich bei der Additionsmethode die Strahlbüschel jeder Quelle erst nach der Blendenebene durchdringen, werden bei der Mischmethode die Strahlbüschel in der Blendenebene überlagert. Die Maximalapertur für jedes Teilsystem ist dabei an den gewünschten Füllgrad der Objektivapertur angepaßt. Ähnlich wie bei der Additionsmethode können gleich aufgebaute Systeme für die einzelnen Quellen gekoppelt werden. Sie sind gleichmäßig um eine gemeinsame Systemachse angeordnet. Gekoppelt werden die Systeme in der Ebene der sekundären Lichtquellen.

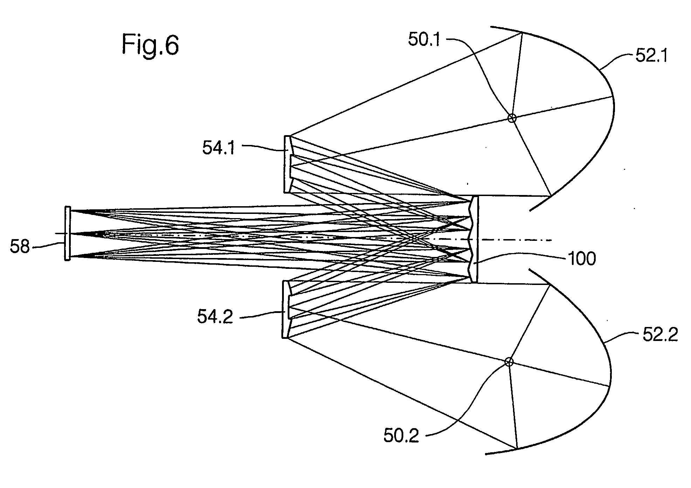

In Figur 6 ist ein Beleuchtungssystem, dem die Mischmethode zur Kopplung mehrerer Lichtquellen zugrundeliegt, gezeigt.

Als Lichtquellen werden wieder Laser-Plasma-Quellen verwandt. Gleiche Bauteile wie in Figur 5 werden mit denselben Bezugsziffern belegt. Im Gegensatz beispielsweise zu Figur 5 ist eine einzige Platte 100, die in eine Vielzahl von Pyramiden gegliedert ist, vorgesehen. Die Pupillenwabenplatte ist am Ort der sekundären Lichtquellen, die von den Feldwaben erzeugt werden, angeordnet. Auf jeder Flanke der Vielzahl von Pyramiden kommt eine sekundäre Lichtquelle zu liegen.

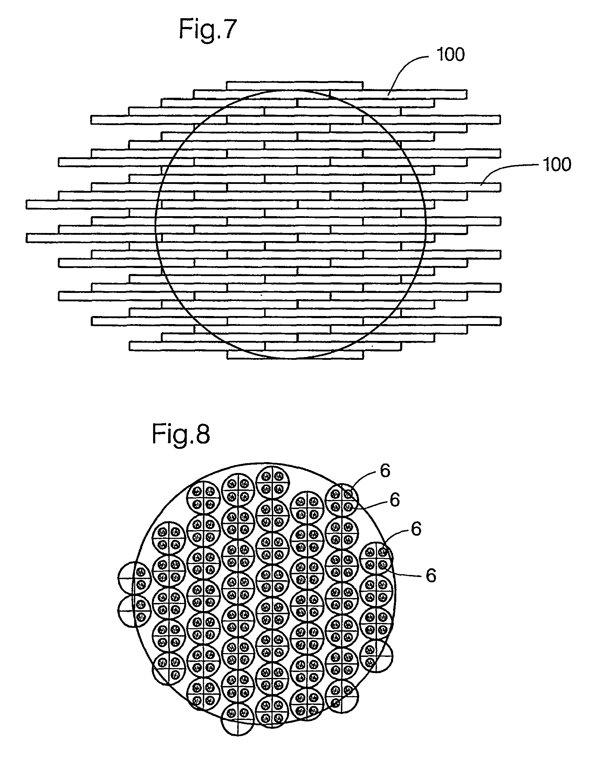

Die schematische Darstellung gemäß Figur 7 zeigt eine typische Anordnung der Feldwaben 110 auf der Feldwabenplatte 102. Die Feldwaben erzeugen in der Blendenebene Gitter von sekundären Lichtquellen, deren Verteilung in der Blendenebene der Anordnung der Feldwaben entspricht.

Durch Verschieben der Teilsysteme kann wie in Figur 8 dargestellt erreicht werden, daß entsprechend der Anzahl der Teilsysteme die Gitter der sekundären Lichtquellen nebeneinander zum Liegen kommen.

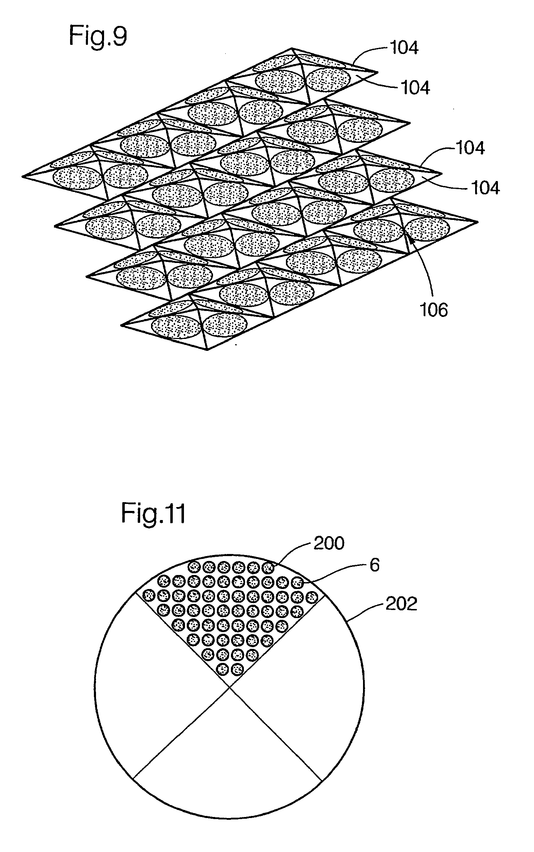

Bei der Kopplung von vier Quellen ergibt sich die in der schematischen Darstellung gemäß Figur 8 wiedergegebene Anordnung der sekundären Lichtquellen 6. Zur korrekten Überlagerung der vier Teilsysteme liegt jedes Set von sekundären Lichtquellen auf jeweils einer verspiegelten Pyramide, deren Flanken so geneigt sind, daß die Lichtbüschel in der Retikelebene überlagert werden. Die schematische Darstellung gemäß Figur 9 zeigt einen Ausschnitt aus der Pupillenwabenplatte. Deutlich zu erkennen die einzelnen Pupillenwaben 104, die von den Flanken einer gleichseitigen Pyramide 106 ausgebildet werden.

Ist der Lichtleitwert (LLW) der einzelnen Quellen klein, so können die Pupillenwaben als Planspiegel ausgelegt werden, das heißt, die Flanken der gleichseitigen Pyramide 106 sind plan ausgebildet.

Bei Quellen mit nicht vernachlässigbarem Quelldurchmesser wie beispielsweise Pinch-Plasma-Quellen, müssen die Pupillenwaben 104 die Feldwaben in die Objektebene, beispielsweise Retikelebene, abbilden. In diesem Fall muß in die Pyramidenflanken eine sammelnde Spiegelfläche 108 eingearbeitet werden.

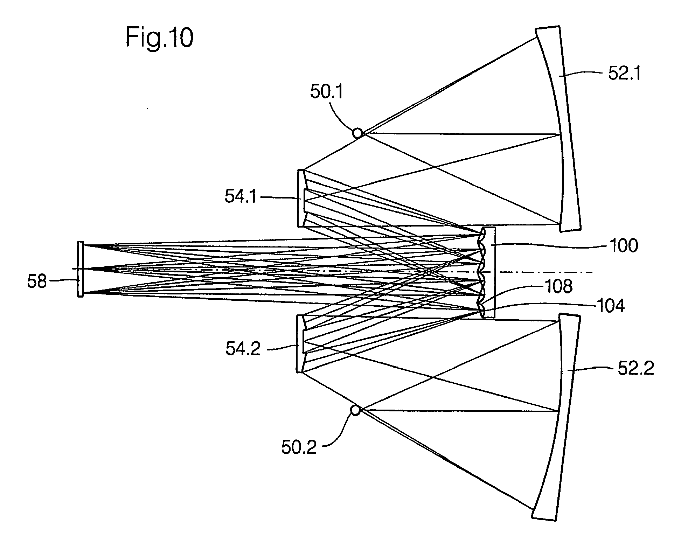

Die schematische Darstellung gemäß Figur 10 zeigt ein System, in dem mehrere Pinch-Plasma-Quellen gekoppelt sind mit einer Pupillenwabenplatte umfassend derartige Pupillenwaben. Gleiche Bauteile wie in Fig. 6 sind mit denselben Bezugsziffern belegt.

Die in den Figuren 5 bis 10 gezeigten Beispiele sind für vier gekoppelte Quellen ausgelegt. Die gleiche Methode läßt sich jedoch auf für drei, fünf, sechs oder mehr Quellen anwenden. Die Verschiebung der Gitter sollte dann so erfolgen, daß die sekundären Lichtquellen auf den Seitenflächen von Pyramiden zu liegen kommen. Der Füllgrad der Pupille ist ähnlich wie bei der Additionsmethode begrenzt.

Die Vorteile der Mischmethode sind, daß die einzelnen Quellen in der Pupillenebene gemischt werden. Intensitätsschwankungen der Quellen zeigen sich nicht in einer inhomogenen Pupillenausleuchtung. Des weiteren kann die Systempupille gleichmäßiger mit sekundären Lichtquellen gefüllt werden.

Als dritte Methode der Kopplung mehrerer Lichtquellen soll die Segmentmethode beschrieben werden.

Die Segmentmethode arbeitet analog zur Additionsmethode. Die gekoppelten Beleuchtungssysteme werden gleichmäßig um eine gemeinsame Systemachse verteilt. Jedem Teilsystem steht dabei in der Blendenebene das entsprechende Segment zum Füllen zu. Statt dieses Segment mit einem Kreis zu füllen wie bei der Additionsmethode kann man durch Ausrichtung der Feldwaben auf der Feldwabenplatte das Segment gleichmäßig auffüllen. Figur 11 zeigt die Ausleuchtung eines Segmentes 200 der Systempupille 202, wenn vier Quellen gekoppelt werden.

Damit die einzelnen Lichtbüschel in der Retikelebene wieder korrekt überlagert werden, müssen am Ort der sekundären Lichtquellen Pupillenwaben angebracht sein, die die Lichtbüschel so umlenken, daß sie in der Retikelebene überlagert werden. Je nach Quellgröße sind die Pupillenwaben plan ausgelegt oder besitzen eine sammelnde Wirkung.

Feld- und Pupillenwaben sind dadurch einzeln und ohne Symmetrie gekippt.

Die Vorteile der Segmentmethode liegen darin, daß durch die paarweise Verkippung von Feld- und Pupillenwabe eine optimale Füllung der Blendenebene mit sekundären Lichtquellen 6 möglich ist.

Obwohl in sämtlichen vorangegangenen Ausführungsbeispielen in den Beleuchtungssystemen den Linsen bzw. Spiegeln mit Rasterelementen nachgeordnete optische Elemente nicht dargestellt wurden, ist für den Fachmann offensichtlich, daß beispielsweise zur Feldformung des Ringfeldes in der Retikelebene den Linsen bzw. Spiegeln mit Rasterelementen nachgeordnete Feldlinsen oder Feldspiegel vorgesehen werden müssen. Diesbezüglich wird betreffend den prinzipiellen Aufbau von EUV-Beleuchtungssystemen auf die weiter oben erwähnten anhängigen Anmeldungen der Anmelderin verwiesen

**Patentansprüche**

1. Beleuchtungssystem für Wellenlängen ≤ 193 nm, insbesondere für die EUV-Lithographie, wobei das Beleuchtungssystem einen Systemlichtleitwert aufweist, umfassend:

   mehrere Lichtquellen (2.1, 2.2) sowie ein Koppelelement (4.1), wobei

   mit Hilfe des Koppelelementes (4.1) die mehrere Lichtquellen (2.1, 2.2) gekoppelt werden,
   wobei die miteinander gekoppelten Lichtquellen einen
   Gesamtlichtleitwert aufweisen und der Gesamtlichtletwert
   den Systemlichtleitwert nicht überschreitet, **dadurch gekennzeichnet, dass** das Koppelelement (4,1) mehrere Spiegelflächen (20.1, 20.2, 20.3, 20.4) umfasst, die gegeneinander geneigt sind.

2. Beleuchtungssystem nach Anspruch 1, **dadurch gekennzeichnet, dass**
   die Spiegelflächen derart gegeneinander geneigt und angeordnet sind, dass eine Feldausleuchtung von Teilsystemen in einer Retikelebene (9) zur Deckung kommt.

3. Beleuchtungssystem nach Anspruch 1 oder 2,
   **dadurch gekennzeichnet, dass**
   die Spiegelflächen (20.1, 20.2, 20.3, 20.4) auf pyramidenförmigen Strukturen angeordnet sind.

4. Beleuchtungssystem nach einem der Ansprüche 1 bis 3, **dadurch gekennzeichnet, dass** das Beleuchtungssystem eine Spiegelvorrichtung zur Erzeugung sekundärer Lichtquellen, der bzw. die in Rasterelemente (56.1, 56.2) gegliedert ist, umfasst.

5. Beleuchtungssystem nach einem der Ansprüche 1 bis 4,
   **dadurch gekennzeichnet, dass**

die Austrittspupille des Beleuchtungssystems bis zu einem vorgegebenen Füllgradausgeleuchtet wird.

6. Beleuchtungssystemnach einem der Ansprüche 1 bis 5, **dadurch gekennzeichnet, dass** die Spiegel der Spiegelvorrichtung zur Erzeugung sekundärer Lichtquellen Rasterelemente zur Feldformung umfassen.

7. Beleuchtungssystem nach Anspruch 6,
**dadurch gekennzeichnet, dass**
die mehreren Spiegel mit Rasterelementen als Feldwabenplatten (54.1, 54.2) ausgebildet sind.

8. Beleuchtungssystem nach der Anspruch 7,
**dadurch gekennzeichnet, dass**
das Koppelelement eine Pyramide ist, die als Träger für die Feldwabenplatten dient.

9. Beleuchtungssystem nach einem der Ansprüche 7 bis 8,
**dadurch gekennzeichnet, dass**
die Rasterelemente auf der Feldwabenplatte derart angeordnet und ausgerichtet sind, dass die Bilder der Rasterelemente in der Objekt- bzw. Retikelebene (58) zur Überlagerung kommen.

10. Beleuchtungssystem nach einem der Ansprüche 7 bis 9,
**dadurch gekennzeichnet, dass**
die Anzahl der Rasterelemente auf jeder Feldwabenplatte gleich ist.

11. Beleuchtungssystem nach einem der Ansprüche 8 bis 10,
**dadurch gekennzeichnet, dass**
die Anzahl der Seiten der Pyramide der Anzahl der gekoppelten Lichtquellen entspricht.

12. Beleuchtungssystem nach einem der Ansprüche 8 bis 11,
**dadurch gekennzeichnet, dass**
die Seiten der Pyramide so ausgerichtet sind, dass die Bilder der Rasterelemente der Feldwabenplatten in der Retikelebene überlagert werden.

13. Beleuchtungssystem nach einem der Ansprüche 1 bis 12,
**dadurch gekennzeichnet, dass**
das Beleuchtungssystem eine weitere Spiegelvorrichtung (56.1, 56.2) umfasst, die mindestens einen Spiegel mit Rasterelementen aufweist.

14. Beleuchtungssystem nach Anspruch 13,
**dadurch gekennzeichnet, dass**
die weitere spiegelvorrichtung (56.1, 56.2) mehrere Spiegel mit Rasterelementen umfasst.

15. Beleuchtungssystem nach einem der Ansprüche 13 bis 14,
**dadurch gekennzeichnet, dass**
die weitere Splegelvorrichtung (56.1, 56.2) am Ort der sekundären Lichtquellen angeordnet ist.

16. Beleuchtungssystem nach einem der Ansprüche 13 bis 14,
**dadurch gekennzeichnet, dass** die Rasterelemente Pupillenwaben sind.

17. Beleuchtungssystem nach Anspruch 16,
**dadurch gekennzeichnet, dass**
die Pupillenwaben auf einer Pupillenwabenplatte angeordnet sind.

18. Beleuchtungssystem nach einem der Ansprüche 1 bis 7,
**dadurch gekennzeichnet,**
**dass** am Ort der sekundären Lichtquellen eine weitere Spiegelvorrichtung (56.1, 56.2), angeordnet ist, wobei die weitere Spiegelvorrichtung Pupillenwaben als Rasterelemente umfasst, die auf einer Pupillenwabenplatte angeordnet sind und
das Koppelelement eine Pyramide ist, die als Träger für die Pupillenwabenplatte dient.

**19.** Beleuchtungssystem nach Anspruch 18,
**dadurch gekennzeichnet, dass**
die Anzahl der Seiten der Pyramide der Anzahl der gekoppelten Lichtquellen entspricht.

**20.** Beleuchtungssystem nach Anspruch 19,
**dadurch gekennzeichnet, dass**
die Seiten der Pyramide so ausgerichtet sind, dass die Bilder der Rasterelemente der Feldwabenplatte in der Retikelebene überlagert werden.

**21.** Beleuchtungssystem nach einem der Ansprüche 1 bis 7,
**dadurch gekennzeichnet, dass**
am Ort der sekundären Lichtquellen eine weitere Spiegelvorrichtung (56.1, 56.2) angeordnet ist, wobei die weitere Spiegelvorrichtung Pupillenwaben als Rasterelemente umfasst und am Ort jeder sekundären Lichtquelle eine Pupillenwabe angeordnet ist, wobei die einzelnen Pupillenwaben auf einer Pyramide als Koppelelement angeordnet sind, wobei auf jeder Pyramidenflanke nur eine sekundäre Lichtquelle zum Liegen kommt.

**22.** Beleuchtungssystem gemäß Anspruch 21,
**dadurch gekennzeichnet, dass**
die Anzahl der Seiten der Pyramide der Anzahl der Lichtquellen entspricht.

**23.** Beleuchtungssystem nach einem der Ansprüche 21 bis 23,
**dadurch gekennzeichnet, dass**
die Pupillenwaben auf den Pyramidenflanken eine sammelnde Spiegelfläche umfassen.

**24.** Beleuchtungssystem nach einem der Ansprüche 21 bis 23,
**dadurch gekennzeichnet, dass**
die Pyramidenflächen plan sind.

**25.** Beleuchtungssystem nach Anspruch 22,
**dadurch gekennzeichnet, dass**
die Seiten der Pyramide so ausgerichtet sind, dass die Bilder der Rasterelemente der Feldwabenplatten in der Retikelebene überlagert werden.

**26.** Beleuchtungssystem nach Anspruch 7,
**dadurch gekennzeichnet, dass**
die Rasterelemente auf der Feldwabenplatte (54.1, 54.2) derart verteilt und gekippt angeordnet sind, dass ein Segment in der Blendenebene des Beleuchtungssystems gleichmäßig mit sekundären Lichtquellen gefüllt wird

**27.** Beleuchtungssystem nach Anspruch 26,
**dadurch gekennzeichnet, dass**
eine weitere Spiegelvorrichtung (56.1, 56.2), die Spiegel mit weiteren Rasterelementen umfasst, am Ort der sekundären Lichtquellen angeordnet Ist.

**28.** Beleuchtungssystem nach Anspruch 27,
**dadurch gekennzeichnet, dass**
die weiteren Rasterelemente der weiteren Spiegelvorrichtung Pupillenwaben (56.1, 56.2, 100) sind.

**29.** Beleuchtungssystem nach Anspruch 28,
**dadurch gekennzeichnet, dass**
die Pupillenwaben (100) plan ausgebildet sind.

**30.** Beleuchtungssystem nach Anspruch 28,
**dadurch gekennzeichnet, dass**
die Pupillenwaben (56.1, 56.2) eine derartige Oberfläche umfassen, dass sie eine sammelnde Wirkung aufweisen.

**31.** Beleuchtungssystem nach einem der Ansprüche 26 bis 30,
**dadurch gekennzeichnet, dass**
die Pupillenwaben derart verteilt und gekippt angeordnet sind, dass sich die Bilder der Feldwaben in der Retikelebene überlagern.

**32.** Beleuchtungssystem nach einem der Ansprüche 1 bis 31,
**dadurch gekennzeichnet, dass**
der Spiegelvorrichtung oder den mehreren Spiegelvorrichtungen mit Spiegeln oder Linsen mit Rasterelementen optische Elemente nachgeordnet sind.

**33.** Beleuchtungssystem nach Anspruch 32,
**dadurch gekennzeichnet, dass**
die optischen Elemente Feldlinsen oder Feldspiegel zur Feldformung umfassen.

**34.** EUV-Projektionsbelichtungsanlage mit einem Beleuchtungssystem nach einem der Ansprüche 1 bis 33
einer Maske
einem Projektionsobjektiv
einem lichtempfindlichen Objekt auf einem Trägersystem.

**35.** EUV-Projektionsbelichtungsanlage gemäß Anspruch 34, ausgeführt als Scanning-System.

**36.** Verfahren zur Herstellung von mikroelektronischen Bauteilen mit einer Projektionsbelichtungsanlage gemäß einem der Ansprüche 34 bis 36.

**Claims**

**1.** An illumination system for wavelengths $\leq$ 193 nm, especially for EUV lithography, with the illumination system having a system etendue, comprising:

several light sources (2,1, 2.2) and a coupling element (4.1), with several light sources (2.1, 2.2) being coupled with the help of the coupling element (4.1), with the mutually coupled light sources having a total etendue and the total etendue not exceeding the system etendue, **characterized in that** the coupling element comprises several mirror surfaces (20.1, 20.2, 20.3, 20.4) which are inclined against each other.

**2.** An illumination system according to claim 1, **characterized in that** the mirror surfaces are arranged and inclined relative to each other in such a way that a field illumination of partial systems comes into coincidence in a reticle plane (9).

**3.** An illumination system according to claim 1 or 2, **characterized in that** the mirror surfaces (20.1, 20.2, 20.3, 20.4) are arranged on pyramidal structures.

**4.** An illumination system according to one of the claims 1 to 3, **characterized in that** the illumination system comprises a mirror apparatus for generating secondary light sources which is structured into raster elements (56.1, 56.2).

**5.** An illumination system according to one of the claims 1 to 4, **characterized in that** the exit pupil of the illumination system is Illuminated up to a predetermined degree of filling.

**6.** An Illumination system according to one of the claims 1 to 5, **characterized in that** the mirrors of the mirror apparatus for generating secondary light sources comprise raster elements for field forming.

**7.** An illumination system according to claim 6, **characterized in that** the several mirrors with raster elements are arranged as field honeycomb plates (54.1,54.2).

**8.** An illumination system according to claim 7, **characterized in that** the coupling element is a pyramid which acts as a carrier for the field honeycomb plates.

**9.** An illumination system according to one of the claims 7 to 8, **characterized in that** the raster elements on the field honeycomb plate is arranged and aligned in such a way that the images of the raster elements come into superposition in the object or reticle plane (58).

**10.** An illumination system according to one of the claims 7 to 9, **characterized in that** the number of raster elements on each field honeycomb plate Is the same.

**11.** An illumination system according to one of the claims 8 to 10, **characterized in that** the number of the sides of the pyramid corresponds to the number of the coupled light sources.

**12.** An illumination system according to one of the claims 8 to 11, **characterized in that** the sides of the pyramid are aligned In such a way that the images of the raster elements of the field honeycomb plates are superposed in the reticle plane.

**13.** An illumination system according to one of the claims 1 to 12, **characterized in that** the illumination system comprises a further mirror apparatus (56.1, 56.2) which comprises at least one mirror with raster elements.

**14.** An illumination system according to claim 13, **characterized in that** the further mirror apparatus (56.1, 56.2) comprises several mirrors with raster elements.

**15.** An illumination system according to one of the claims 13 to 14, **characterized in that** the further mirror apparatus (56.1, 56.2) is arranged at the location of the secondary light sources.

**16.** An illumination system according to one of the claims 13 to 14, **characterized in that** the raster elements are pupil honeycombs.

**17.** An illumination system according to claim 16, **characterized in that** the pupil honeycombs are arranged on a pupil honeycomb plate.

**18.** An illumination system according to one of the claims 1 to 7, **characterized in that** a further mirror apparatus (56,1, 56.2) is arranged at the location of the secondary light sources, with the further mirror apparatus comprising pupil honeycombs as raster elements which are arranged on a pupil honeycomb plate and the coupling element is a pyramid which is used as a carrier for the pupil honeycomb plate.

**19.** An illumination system according to claim 18, **characterized in that** the number of the sides of the pyramid corresponds to the number of the coupled light sources.

**20.** An illumination system according to claim 19, **characterized in that** the sides of the pyramid are aligned in such a way that the images of the raster elements of the field honeycomb plate are superposed in the reticle plane.

**21.** An illumination system according to one of the claims 1 to 7, **characterized in that** a further mirror apparatus (56.1, 56.2) is arranged at the location of the secondary light sources, with the further mirror apparatus comprising pupil honeycombs as raster elements and a pupil honeycomb is arranged at the location of each secondary light source, with the Individual pupil honeycombs being arranged on a pyramid as a coupling element, with only one secondary light source coming to lie on each pyramid flank.

**22.** An illumination system according to claim 21, **characterized in that** the number of the sides of the pyramid corresponds to the number of light sources.

**23.** An illumination system according to one of the claims 21 to 23, **characterized in that** the pupil honeycombs comprise a collecting mirror surface on the pyramid flanks.

**24.** An illumination system according to one of the claims 21 to 23, **characterized in that** the pyramid surfaces are plane.

**25.** An illumination system according to claim 22, **characterized in that** the sides of the pyramid are aligned in such a way that the images of the raster elements of the field honeycomb plates are superposed in the reticle plane.

**26.** An illumination system according to claim 7, **characterized in that** the raster elements on the field honeycomb plate (54.1, 54.2) are distributed and arranged in a tilted manner In such a way that a segment in the diaphragm plane of the illumination system is filed evenly with secondary light sources.

**27.** An illumination system according to claim 26, **characterized in that** a further mirror apparatus (56.1, 56.2) which comprises mirrors with further raster elements is arranged at the location of the secondary light sources.

28. An illumination system according to claim 27, **characterized in that** the further raster elements of the further mirror apparatus are pupil honeycombs (56.1, 56.2, 100).

29. An illumination system according to claim 28, **characterized in that** the pupil honeycombs are provided with a planar configuration.

30. An illumination system according to claim 28, **characterized in that** the pupil honeycombs (56.1, 56.2) comprise such a surface that they have a collecting effect.

31. An illumination system according to one of the claims 26 to 30, **characterized in that** the pupil honeycombs are distributed and arranged in a tilted manner in such a way that the images of the field honeycombs are superposed in the reticle plane.

32. An illumination system according to one of the claims 1 to 31, **characterized in that** the mirror apparatus or the several mirror apparatuses with mirrors or lenses with raster elements are provided downstream with optical elements.

33. An illumination system according to claim 32, **characterized in that** the optical elements comprise field lenses or field mirrors for field forming.

34. An EUV projection exposure system with an illumination system according to one of the claims 1 to 33, a mask, a projection objective, and a light-sensitive object on a support system.

35. An EUV projection exposure system according to claim 34, arranged as a scanning system.

36. A method for producing microelectronic components with a projection exposure system according to one of the claims 34 to 36.


**Revendications**

1. Système d'éclairage pour des longueurs d'onde ≤ 193 nm, en particulier pour la lithographie EUV, lequel système d'éclairage possède un facteur de conduction lumineuse du système, comprenant plusieurs sources lumineuses (2.1, 2.2) et un élément de couplage (4.1), dans lequel les multiples sources lumineuses (2.1, 2.2) sont couplées à l'aide de l'élément de couplage (4.1), les sources lumineuses (2.1, 2.2) couplées entre elles ayant un facteur de conduction lumineuse total et le facteur de conduction lumineuse total ne dépassant pas le facteur de conduction lumineuse du système, **caractérisé en ce que** l'élément de couplage (4.1) comprend plusieurs surfaces de miroir (20.1, 20.2, 20.3, 20.4) inclinées les unes vers les autres,

2. Système d'éclairage selon la revendication 1, **caractérisé en ce que** les surfaces de miroir sont inclinées les unes vers les autres et disposées de telle sorte qu'un éclairage du champ par des parties du système se recoupe dans un plan de réticule (9).

3. Système d'éclairage selon la revendication 1 ou 2, **caractérisé en ce que** les surfaces de miroir (20.1, 20.2, 20.3, 20.4) sont disposées sur des structures pyramidales.

4. Système d'éclairage selon l'une des revendications 1 à 3, **caractérisé en ce que** le système d'éclairage comprend un dispositif de miroirs destiné à créer des sources lumineuses secondaires (2.1, 2.2) organisées en éléments de grille (56.1, 56.2).

5. Système d'éclairage selon l'une des revendications 1 à 4, **caractérisé en ce que** la pupille de sortie du système d'éclairage est éclairée jusqu'à un degré de remplissage prédéterminé.

6. Système d'éclairage selon l'une des revendications 1 à 5, **caractérisé en ce que** les miroirs du dispositif de miroirs pour la création de sources lumineuses secondaires (2.1, 2.2) comprennent des éléments de grille pour la mise en forme du champ.

**7.** Système d'éclairage selon la revendication 6, **caractérisé en ce que** les multiples miroirs sont conformés avec des éléments de grille sous la forme de plaques de champ alvéolées (54.1, 54.2).

**8.** Système d'éclairage selon la revendication 7, **caractérisé en ce que** l'élément de couplage est une pyramide qui sert de support pour les plaques de champ alvéolées.

**9.** Système d'éclairage selon l'une des revendications 7 à 8, **caractérisé en ce que** les éléments de grille sont disposés sur la plaque de champ alvéolée et orientés de telle manière que les images des éléments de grille dans le plan d'objet ou de réticule (59) se superposent.

**10.** Système d'éclairage selon l'une des revendications 7 bis 9, **caractérisé en ce que** le nombre d'éléments de grille est le même sur chaque plaque de champ alvéolée.

**11.** Système d'éclairage selon l'une des revendications 8 à 10, **caractérisé en ce que** le nombre de faces de la pyramide correspond au nombre de sources lumineuses couplées.

**12.** Système d'éclairage selon l'une des revendications 8 à 11, **caractérisé en ce que** les faces de la pyramide sont orientées de telle manière que les images des éléments de grille des plaques de champ alvéolées sont superposées dans le plan de réticule.

**13.** Système d'éclairage selon l'une des revendications 1 à 12, **caractérisé en ce que** le système d'éclairage comprend un autre dispositif de miroirs (56.1, 56.2) comprenant au moins un miroir avec des éléments de grille.

**14.** Système d'éclairage selon la revendication 13, **caractérisé en ce que** l'autre dispositif de miroirs (56.1, 56.2) comporte des miroirs avec des éléments de grille.

**15.** Système d'éclairage selon l'une des revendications 13 à 14, **caractérisé en ce que** l'autre dispositif de miroirs (56.1, 56.2) est disposé à l'emplacement des sources lumineuses secondaires.

**16.** Système d'éclairage selon l'une des revendications 13 à 14, **caractérisé en ce que** les éléments de grille sont des alvéoles de pupille.

**17.** Système d'éclairage selon la revendication 16, **caractérisé en ce que** les alvéoles de pupille sont disposées sur une plaque d'alvéoles de pupille.

**18.** Système d'éclairage selon l'une des revendications 1 à 7, **caractérisé en ce qu'**il est prévu à l'emplacement des sources lumineuses secondaires un autre dispositif de miroirs (56.1, 56.2), lequel autre dispositif de miroirs comporte comme éléments de grille des alvéoles de pupille disposées sur une plaque d'alvéoles de pupille et l'élément de couplage est une pyramide servant de support à la plaque d'alvéoles de pupille.

**19.** Système d'éclairage selon la revendication 18, **caractérisé en ce que** le nombre de faces de la pyramide correspond au nombre de sources lumineuses couplées.

**20.** Système d'éclairage selon la revendication 19, **caractérisé en ce que** les faces de la pyramide sont orientées de telle façon que les images des éléments de grille de la plaque de champ alvéolée se superposent dans le plan de réticule.

**21.** Système d'éclairage selon l'une des revendications 1 à 7, **caractérisé en ce qu'**il est prévu à l'emplacement des sources lumineuses secondaires un autre dispositif de miroirs (56.1, 56.2), lequel autre dispositif de miroirs comprend des alvéoles de pupille servant d'éléments de grille et il est prévu à l'emplacement de chaque source lumineuse secondaire une alvéole de pupille, les différentes alvéoles de pupille étant disposées sur une pyramide servant d'élément de couplage et une seule source lumineuse secondaire venant reposer sur chaque flanc de la pyramide.

**22.** Système d'éclairage selon la revendication 21, **caractérisé en ce que** le nombre de faces de la pyramide correspond au nombre des sources lumineuses,

**23.** Système d'éclairage selon l'une des revendications 21 à 23, **caractérisé en ce que** les alvéoles de pupille circonscrivent une surface de miroir collectrice sur les flancs de la pyramide.

**24.** Système d'éclairage selon l'une des revendications 21 à 23, **caractérisé en ce que** les faces de la pyramide sont planes.

**25.** Système d'éclairage selon la revendication 22, **caractérisé en ce que** les faces de la pyramide sont orientées de telle façon que les images des éléments de grille des plaques de champ alvéolées se superposent dans le plan de réticule,

**26.** Système d'éclairage selon la revendication 7, **caractérisé en ce que** les éléments de grille sont disposés sur la plaque de champ alvéolée (54.1, 54.2) et inclinés de telle façon qu'un segment se trouvant dans le plan de diaphragme du système d'éclairage soit rempli de façon uniforme par les sources lumineuses secondaires.

**27.** Système d'éclairage selon la revendication 26, **caractérisé en ce qu'**il est prévu un autre dispositif de miroirs (56.1, 56.2), comprenant des miroirs avec d'autres éléments de grille, à l'emplacement des sources lumineuses secondaires.

**28.** Système d'éclairage selon la revendication 27, **caractérisé en ce que** les autres éléments de grille de l'autre dispositif de miroirs sont des alvéoles de pupille (56.1, 56.2, 100).

**29.** Système d'éclairage selon la revendication 28, **caractérisé en ce que** les alvéoles de pupille ont une forme plane.

**30.** Système d'éclairage selon la revendication 28, **caractérisé en ce que** les alvéoles de pupille (56.1, 56.2) circonscrivent une surface telles qu'ils ont un effet collecteur.

**31.** Système d'éclairage selon l'une des revendications 26 à 30, **caractérisé en ce que** les alvéoles de pupille sont réparties et inclinées de telle façon que les images des champs d'alvéoles se superposent dans le plan de réticule.

**32.** Système d'éclairage selon l'une des revendications 1 bis 31, **caractérisé en ce que** des éléments optiques sont montés à la suite du dispositif de miroirs ou des multiples dispositifs de miroir pourvus de miroirs ou de lentilles avec des éléments de grille.

**33.** Système d'éclairage selon la revendication 32, **caractérisé en ce que** les éléments optiques comprennent des lentilles de champ ou des miroirs de champ pour la mise en forme du champ.

**34.** Installation d'éclairage EUV de projection avec un système d'éclairage selon l'une des revendications 1 à 33, un masque
un objectif de projection
un objet photosensible sur un système de support.

**35.** Installation d'éclairage EUV de projection selon la revendication 34, réalisée sous la forme d'un système de scannage.

**36.** Procédé pour la fabrication de composants microélectroniques avec une Installation d'éclairage de projection selon l'une des revendications 34 à 36.

## Fig.1

## Fig.2

## Fig.3

$NA_{OBj} = 0,025$

$NA_{Teilsystem} = 0,0104$

30.4  30.3

30.3  6

6

30.3

## Fig.4A

$NA_{Teilsystem} = NA_{OBj} / 2,155$

30.1  30.2

30.3

## Fig.4B

30.1  $NA_{Teilsystem} = NA_{OBj} / 2,414$

30.2

30.4  30.3

## Fig.4C

30.5  $NA_{Teilsystem} = NA_{OBj} / 2,701$

30.4  30.1

30.3  30.2

## Fig.4D

30.6  $NA_{Teilsystem} = NA_{OBj} / 3,000$

30.5  30.1

30.4  30.2

30.3

Fig.5

50.1

52.1

54.1

56.1

58

56.2

54.2

52.2

50.2

EP 1 072 957 B1

Fig.6

52.1

52.2

100

50.1

50.2

54.1

54.2

58

## Fig.7

## Fig.8

Fig.9

104

104

104

104

106

Fig.11

200

6

202

Fig.10